# EUROPEAN PATENT APPLICATION

(11) **EP 4 329 428 A1**
(43) Date of publication of application: **28.02.2024**
(21) Application number: 23193581.8
(22) Date of filing: 25.08.2023
(51) Int. Cl.: H05B 6/10

(54) **INDUCTION HEATING WITH REDUCED MAGNETIC FIELDS**

(30) Priority: 26.08.2022 US 202263373672 P; 26.04.2023 US 202318307478
(71) Applicant: The Boeing Company, Arlington, VA 22202 (US)
(72) Inventor: Voss, Bret Alan Mcginness, Arlington 22202 (US); Matsen, Marc R., Arlington 22202 (US)
(74) Representative: Arnold & Siedsma

(57) **Abstract**

An induction heating system and methods of forming an induction heating system are presented. The induction heating system comprises a conductor, a susceptor surrounding the conductor, and magnetic field reduction. The susceptor has a Curie temperature. The magnetic field reduction is configured to reduce magnetic fields escaping the induction heating system when the susceptor is at the Curie temperature independent of a layout of the induction heating system within an induction heating device.

## Description

This application claims the benefit of U.S. Provisional Patent Application Serial No. 63/373,672, filed August 26, 2022, and entitled "Induction Heating with Reduced Magnetic Fields,".

### BACKGROUND INFORMATION

### Field:

The present disclosure relates generally to methods and equipment for out-of-autoclave curing of composite parts and deals more particularly with a method and equipment for induction heating with reduced magnetic fields outside of the induction heating circuit.

### Background:

In conventional induction heating circuits, the flow of alternating current through a conductor of the circuit results in a magnetic field. The susceptor and conductor are designed such that at temperatures below the Curie temperature of the susceptor, the magnetic field can be concentrated in the susceptor due to its magnetic permeability.

At, near, or on reaching Curie temperature, the susceptor becomes non-ferromagnetic. The magnetic fields are no longer concentrated in the susceptor when the susceptor becomes non-ferromagnetic. Magnetic fields escape conventional induction heating circuits when the susceptors are near or reach a respective Curie temperature.

FCC regulations include electromagnetic emission regulations. Currently, induction heating circuits are arranged in parallel circuit patterns to cancel long range electromagnetic effects from adjacent circuits to remain below FCC regulated limits of magnetic fields. In some instances, lower frequency is used in induction heating circuits to remain below FCC regulated limits of magnetic fields.

Therefore, it would be desirable to have a method and apparatus that takes into account at least some of the issues discussed above, as well as other possible issues. For example, it would be desirable to have greater flexibility in induction heating circuit layout. In some instances, it would be desirable to use higher frequency power sources.

### SUMMARY

The present disclosure provides an induction heating system. The induction heating system comprises a conductor, a susceptor surrounding the conductor, and a magnetic field reduction. The susceptor has a Curie temperature. The magnetic field reduction is configured to reduce magnetic fields escaping the induction heating system, preferably when the susceptor is at the Curie temperature independent of a layout of the induction heating system within an induction heating device.

The present disclosure also provides an induction heating circuit. The induction heating circuit comprises a conductor, a susceptor having a Curie temperature surrounding the conductor, and a shielding of conductive metal surrounding the susceptor and the conductor configured to reduce magnetic fields escaping the induction heating circuit, preferably when the susceptor is at the Curie temperature.

The present disclosure provides an induction heating system. The induction heating system comprises a first induction heating circuit having a first current direction, and a second induction heating circuit twisted around the first induction heating circuit and a central axis. The second induction heating circuit has a second current direction opposite of the first current direction.

The present disclosure provides a method of reducing magnetic fields escaping an induction heating system during induction heating. An induction heating circuit is surrounded with shielding. The induction heating circuit comprises a conductor and a susceptor surrounding the conductor. The susceptor has a Curie temperature, and the shielding is configured to reduce magnetic fields escaping the induction heating circuit, preferably when the susceptor is at the Curie temperature. The induction heating circuit is positioned into a layout in an induction heating device to form the induction heating system.

The present disclosure provides a method of reducing magnetic fields escaping an induction heating system during induction heating. A first induction heating circuit and a second induction heating circuit are wrapped around a central axis to form a pair of induction heating circuits twisted around the central axis, the pair of induction heating circuits having opposite current directions. Power is applied to the first induction heating circuit and the second induction heating circuit. The magnetic fields from each of the first induction heating circuit and the second induction heating circuit are canceled out by the opposite current directions as power is applied to the first induction heating circuit and the second induction heating circuit.

According to an example there is provided an induction heating system comprising a conductor, a susceptor surrounding the conductor, the susceptor having a Curie temperature; and magnetic field reduction configured to reduce magnetic fields escaping the induction heating system, preferably when the susceptor is at the Curie temperature independent of a layout of the induction heating system within an induction heating device.

The magnetic field reduction can be shielding surrounding the susceptor.

The shielding can comprise a spiral of conductive metal; a braid of conductive metal; and/or a foil of conductive metal.

The shielding may comprise copper or aluminum. The magnetic field reduction may comprise a design of a pair of induction heating circuits twisted around a central axis, wherein the pair of induction heating circuits have opposite current directions, and wherein a first induction heating circuit of the pair of induction heating circuits comprises the conductor and the susceptor.

The induction heating system comprises a bend such that the pair of induction heating circuits is formed of the conductor and the susceptor.

The pair of induction heating circuits may further comprise a second induction heating circuit comprising a second conductor and a second susceptor.

According to an example there is provided an induction heating circuit comprising a conductor, a susceptor having a Curie temperature surrounding the conductor; and a shielding of conductive metal surrounding the susceptor and the conductor configured to reduce magnetic fields escaping the induction heating circuit, preferably when the susceptor is at the Curie temperature.

The shielding may comprise a spiral of conductive metal, a braid of conductive metal and/or a foil of conductive metal. The shielding may comprise copper or aluminum.

According to an example there is provided an induction heating system comprising, a first induction heating circuit having a first current direction; and a second induction heating circuit twisted around the first induction heating circuit and a central axis, the second induction heating circuit having a second current direction opposite of the first current direction.

The first induction heating circuit and the second induction heating circuit can be connected by a bend such that the first induction heating circuit and the second induction heating circuit are formed by a same conductor and a same susceptor surrounding the same conductor.

The first induction heating circuit and the second induction heating circuit can be formed by separate lengths of conductor surrounded by susceptor, the first induction heating circuit and second induction heating circuit having separate electrical buses.

The first induction heating circuit and the second induction heating circuit may each comprise shielding configured to reduce magnetic fields escaping a respective induction heating circuit, preferably when a respective susceptor is at a Curie temperature of the respective susceptor.

Shielding for each of the first induction heating circuit and the second induction heating circuit may comprise conductive metal and is at least one of a braid, a foil, or a spiral.

The first induction heating circuit and the second induction heating circuit can be a twisted pair of induction heating circuits, the induction heating system further comprising shielding surrounding the twisted pair of induction heating circuits, the shielding configured to reduce magnetic fields escaping the twisted pair of induction heating circuits, preferably when the twisted pair of induction heating circuits are at a Curie temperature of the twisted pair of induction heating circuits.

According to an example there is provided a method of reducing magnetic fields escaping an induction heating system during induction heating, the method comprising surrounding an induction heating circuit with shielding, the induction heating circuit comprising a conductor and a susceptor surrounding the conductor, the susceptor having a Curie temperature, and the shielding configured to reduce magnetic fields escaping the induction heating circuit, preferably when the susceptor is at the Curie temperature and positioning the induction heating circuit into a layout in an induction heating device to form the induction heating system.

Surrounding the induction heating circuit with shielding may comprise wrapping the conductor and the susceptor in a spiral of conductive metal.
Surrounding the induction heating circuit with shielding can comprise braiding a conductive metal around the conductor and the susceptor.

Surrounding the induction heating circuit with shielding can comprise wrapping the conductor and the susceptor in a foil of conductive metal.

Surrounding the induction heating circuit with shielding may comprise braiding a conductive metal around the conductor and the susceptor and wrapping the conductor and the susceptor in a foil of conductive metal.
Positioning the induction heating circuit into a layout can comprise positioning the induction heating circuit into the layout that is non-serpentine.

According to an example there is provided a method of reducing magnetic fields escaping an induction heating system during induction heating, the method comprising, wrapping a first induction heating circuit and a second induction heating circuit around a central axis to form a pair of induction heating circuits twisted around the central axis, the pair of induction heating circuits having opposite current directions, applying power to the first induction heating circuit and the second induction heating circuit, and canceling out the magnetic fields from each of the first induction heating circuit and the second induction heating circuit by the opposite current directions as power is applied to the first induction heating circuit and the second induction heating circuit.

The pair of induction heating circuits can be positioned into a layout to form the induction heating system in an induction heating device, wherein the opposite current directions cancel out the magnetic fields independent of the layout. The layout is preferably non-serpentine.

### BRIEF DESCRIPTION OF THE DRAWINGS

**Figure 1** is an illustration of an aircraft in which the disclosure may be implemented;
**Figure 2** is an illustration of a block diagram of a manufacturing environment in which the disclosure may be implemented;
**Figure 3** is an illustration of a cross-sectional view of an induction heating circuit in accordance with the disclosure;
**Figure 4** is an illustration of a cross-sectional view of an induction heating circuit in accordance with the disclosure;
**Figure 5** is an illustration of a partially exploded view of an induction heating circuit with spiral shielding in accordance with the disclosure;
**Figure 6** is an illustration of a partially exploded view of an induction heating circuit with foil shielding in accordance with the disclosure;
**Figure 7** is an illustration of a partially exploded view of an induction heating circuit with braided shielding in accordance with the disclosure;
**Figure 8** is an illustration of a partially exploded view of an induction heating circuit with foil and braided shielding in accordance with the disclosure;
**Figure 9** is an illustration of a side view of an induction heating system with a twisted pair of induction heating circuits in accordance with the disclosure;
**Figure 10** is an illustration of a cross-sectional view of an induction heating system with a twisted pair of induction heating circuits in accordance with the disclosure;
**Figure 11** is an illustration of a cross-sectional view of an induction heating system with a twisted pair of induction heating circuits in accordance with the disclosure;
**Figure 12** is a flowchart of a method of reducing magnetic fields escaping an induction heating system during induction heating in accordance with the disclosure;
**Figure 13** is a flowchart of a method of reducing magnetic fields escaping an induction heating system during induction heating in accordance with the disclosure;
**Figure 14** is an illustration of an aircraft manufacturing and service method in a form of a block diagram in accordance with the disclosure; and
**Figure 15** is an illustration of an aircraft in a form of a block diagram in which the disclosure may be implemented.

### DETAILED DESCRIPTION

The disclosure recognizes and take into account one or more different considerations. The disclosure recognizes and take into account that a composite part can be cured in an oven or an autoclave where heat is applied to the part while supported on a cure tool that maintains the shape of the part during the curing process. The disclosure recognizes and takes into account that curing the composite material using an autoclave may use at least one of undesirable amount of time or an undesirable amount of energy.
The disclosure recognizes and takes into account that induction heating techniques have been developed for curing composite parts without the need for an oven or autoclave, however these techniques have been limited by the frequency of the induction current and the design of the induction tools.

The disclosure recognizes and take into account that higher frequency power supplies generate higher currents which can generate high electromagnetic emissions. The disclosure recognizes and takes into account that electromagnetic noise could interfere with electronics. The disclosure also recognizes and takes into account that there are FCC regulations regarding electromagnetic emissions. The disclosure recognizes and takes into account that eddy currents can undesirably generate heat in surrounding materials.

The disclosure recognizes and take into account that conventional induction heating circuits are arranged in parallel circuit patterns to cancel electromagnetic effect from adjacent circuits. The disclosure recognizes and takes into account that currently lower frequency is used in induction heating circuits to remain below FCC regulated limits of magnetic fields.

The disclosure recognizes and takes into account that it may be desirable to utilize power supplies with higher frequencies without generating high electromagnetic emissions. The disclosure recognizes and takes into account that it would be desirable to have greater flexibility in the design of induction heating tools.

The disclosure provides an induction heating system. The induction heating system comprises a conductor, a susceptor surrounding the conductor, and a magnetic field reduction. The susceptor has a Curie temperature. The magnetic field reduction is configured to reduce magnetic fields escaping the induction heating system, preferably when the susceptor is at the Curie temperature independent of a layout of the induction heating system within an induction heating device.

The disclosure provides greater flexibility in the layout of induction heating circuits.
The disclosure provides an induction heating system that generates lower electromagnetic emission.

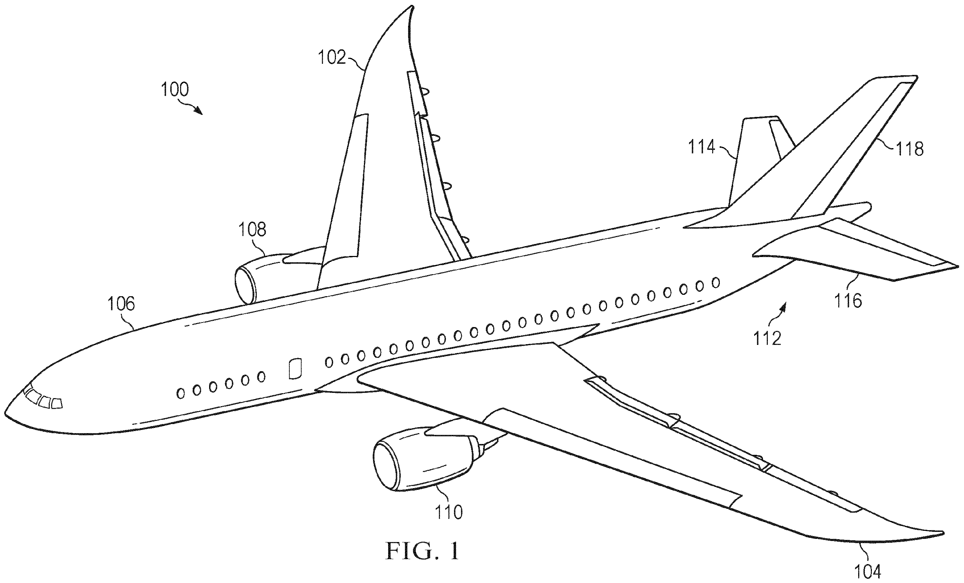

Turning now to **Figure 1****,** an illustration of an aircraft is depicted in accordance with the disclosure. Aircraft **100** has wing **102** and wing **104** attached to body **106.** Aircraft **100** includes engine **108** attached to wing **102** and engine **110** attached to wing **104.**

Body **106** has tail section **112.** Horizontal stabilizer **114,** horizontal stabilizer **116,** and vertical stabilizer **118** are attached to tail section **112** of body **106.**
Aircraft **100** is an example of an aircraft having large composite components that can be manufactured using an induction heating system having magnetic field reduction. For example, portions of body **106,** wing **102,** or wing **104** can be manufactured using an induction heating system having magnetic field reduction.

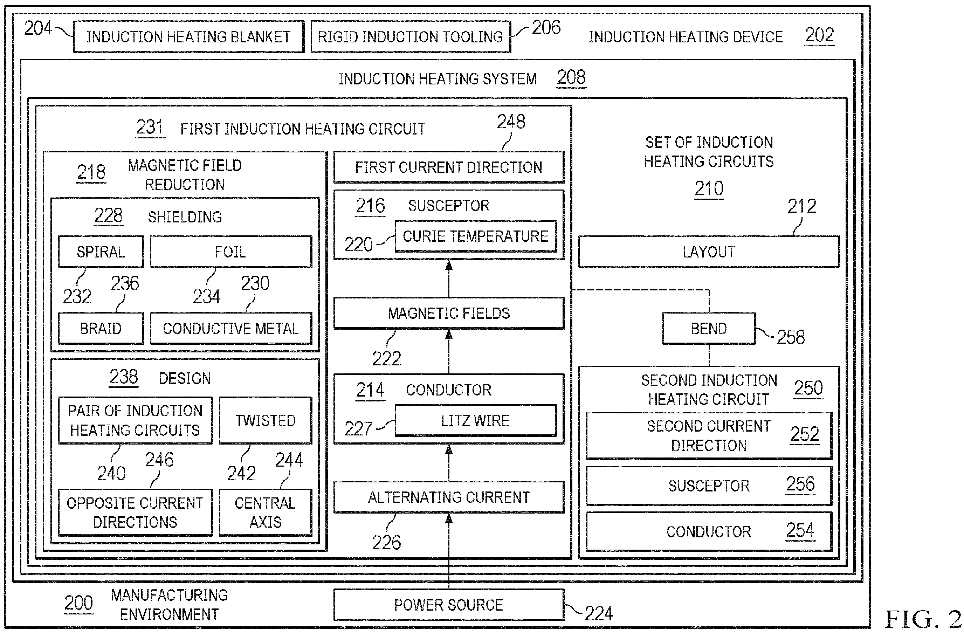

Turning now to **Figure 2****,** an illustration of a block diagram of a manufacturing environment is depicted in which the disclosure may be implemented. Manufacturing environment **200** is a manufacturing environment in which a component of aircraft **100** can be manufactured. For example, a portion of body **106,** wing **102,** or wing **104** could be manufactured using induction heating device **202** in manufacturing environment **200.**

Induction heating device **202** can take the form of induction heating blanket **204** or rigid induction tooling **206.** Induction heating device **202** comprises induction heating system **208** to provide heat in induction heating device **202.** Induction heating system **208** comprises set of induction heating circuits **210** having layout **212** in induction heating device **202.** As used herein, a "set of" items is one or more items. For example, set of induction heating circuits **210** is one or more induction heating circuits.

Induction heating system **208** comprises conductor **214,** susceptor **216** surrounding conductor **214,** and magnetic field reduction **218.** Susceptor **216** has Curie temperature **220.** Magnetic field reduction **218** is configured to reduce magnetic fields **222** escaping induction heating system **208** when susceptor **216** is at, near or approaching Curie temperature **220** independent of layout **212** of induction heating system **208** within induction heating device **202.**

Magnetic field reduction **218** allows layout **212** of set of induction heating circuits **210** to deviate from conventional parallel designs without unacceptable emissions of magnetic fields **222.** Magnetic field reduction **218** allows layout **212** of set of induction heating circuits **210** to be non-serpentine.

Positioning set of induction heating circuits into layout **212** may comprise positioning a set of induction heating circuits into layout **212** that is non-serpentine. Magnetic field reduction **218** enables non-serpentine layouts of sets of induction heating circuits **210** without undesirable quantities of magnetic emissions.

Susceptor **216** comprises a metal, an alloy, or any other suitable material that is electrically conducting and having Curie temperature **220** in a range for performing a desired operation on a material. Susceptor **216** may comprise at least one of iron, cobalt, nickel, molybdenum, or chromium.
Power source **224** provides alternating current **226** to conductor **214.** Conductor **214** receives alternating current **226** and generates magnetic fields **222** in response to alternating current **226.** Conductor **214** comprises any desirable material having low electrical resistance. Conductor **214** may be formed of a flexible material to enable use of first induction heating circuit **231** in induction heating blanket **204.** Conductor **214** may be formed of a flexible material to enable the use of conductor **214** in curved surfaces. Conductor **214** can comprise Litz wire **227.** Susceptor **216** is a magnetic material located adjacent to conductor **214.** The magnetic material generates heat in response to magnetic fields **222.** Curie temperature **220** is a temperature at which susceptor **216** becomes non-ferromagnetic. The heating of susceptor **216** due to magnetic fields **222** ceases when susceptor **216** reaches, or is near, Curie temperature **220.**

Susceptor **216** may be referred to as a "smart susceptor". Susceptor **216** extends along conductor **214.** Susceptor **216** can be coaxially mounted to conductor **214** and electrically insulated from conductor **214** for induction heating in response to magnetic fields **222.**

The magnetic field reduction **218** may comprise shielding **228** surrounding susceptor **216.** Shielding **228** blocks magnetic fields **222** from escaping first induction heating circuit **231.** By blocking magnetic fields **222,** shielding **228** reduces magnetic fields **222** escaping induction heating system **208.** Shielding **228** is formed of conductive metal **230.** Conductive metal **230** is selected based on at least one of conduction, cost, and manufacturability. Conductive metal **230** can be selected from copper or aluminum. Shielding **228** can comprise copper or aluminum.
Shielding **228** can physically block magnetic fields **222** from exiting first induction heating circuit **231,** preferably after susceptor **216** reaches Curie temperature **220.** Shielding **228** may block magnetic fields **222** from exiting first induction heating circuit **231** using an induced current with an opposing field in shielding **228** preferably after susceptor **216** reaches Curie temperature **220.**

Slight heating can occur in shielding **228** when using an induced current to block magnetic fields **222.** The low electrical resistance of conductive metal **230** of shielding **228** is selected to reduce heating occurring in shielding **228** when a current is applied. Shielding **228** may comprise a combination of physical blocking of magnetic fields **222** and current induced blocking of magnetic fields **222.** Here the ratio and combination of physical blocking and current induced blocking is engineered based on the application. Shielding **228** can comprise spiral **232** of conductive metal **230.** Shielding **228** can comprise foil **234** of conductive metal **230.** Shielding **228** can comprise braid **236** of conductive metal **230.**

Magnetic field reduction **218** can comprise design **238** of pair of induction heating circuits **240** twisted **242** around central axis **244.** Pair of induction heating circuits **240** have opposite current directions **246.** First induction heating circuit **231** of pair of induction heating circuits **240** comprises conductor **214** and susceptor **216** and has first current direction **248.** Second induction heating circuit **250** having second current direction **252** comprises susceptor **256** and conductor **254.**

Induction heating system **208** may comprise first induction heating circuit **231** having first current direction **248** and a second induction heating circuit **250** twisted **242** around first induction heating circuit **231** and central axis **244,** the second induction heating circuit **250** having a second current direction **252.**

The twisted **242** pair of induction heating circuits **240** can generate a higher magnetic field (B) intensity. The space between the wires may have 2xB. Higher magnetic field intensity will increase Curie temperature **220** drop-off and improve 'smartness' of twisted **242** pair of induction heating circuits **240.**

Design **238** of twisted **242** pair of induction heating circuits **240** provides cancellation of magnetic fields **222.** Field intensity between first induction heating circuit **231** and second induction heating circuit **250** increases, but the direction changes as each of the induction heating circuits twist. The sum of magnetic fields for first induction heating circuit **231** and second induction heating circuit **250** can be closer to zero than conventional parallel wire designs.

The first induction heating circuit **231** and second induction heating circuit **250** are preferably connected by bend **258** such that first induction heating circuit **231** and second induction heating circuit **250** are formed by a same conductor and a same susceptor surrounding the conductor. Here the susceptor **216** and susceptor **256** are formed of a single length of susceptor. The induction heating system **208** may comprise a bend such that pair of induction heating circuits **240** is formed of conductor **214** and susceptor **216.**

The pair of induction heating circuits **240** may comprise second induction heating circuit **250** comprising a second conductor, conductor **254,** and a second susceptor, susceptor **256.** Here a first induction heating circuit **231** and second induction heating circuit **250** have independent lengths of susceptor and independent lengths of conductor.

First induction heating circuit **231** may comprise conductor **214;** susceptor **216** having Curie temperature **220** surrounding conductor **214;** and shielding **228** of conductive metal **230** surrounding susceptor **216** and conductor **214.** Shielding **228** is configured to reduce magnetic fields **222** escaping first induction heating circuit **231** when susceptor **216** is at, or near Curie temperature **220.**

First induction heating circuit **231** and second induction heating circuit **250** can be formed by separate lengths of conductor surrounded by susceptor, first induction heating circuit **231** and second induction heating circuit **250** having separate electrical buses. Susceptor **216** can be a separate length from susceptor **256.** Conductor **214** can be a separate length from conductor **254.**

First induction heating circuit **231** and the second induction heating circuit may each comprise shielding **228** configured to reduce magnetic fields escaping a respective induction heating circuit, preferably when a respective susceptor is at a Curie temperature of the respective susceptor. Shielding **228** for each of first induction heating circuit **231** and second induction heating circuit **250** comprises conductive metal and is at least one of a braid, a foil, or a spiral.

Magnetic field reduction **218** enables larger spacing between adjacent portions of set of induction heating circuits **210** without undesirable magnetic emissions. Magnetic field reduction **218** enables layout **212** that is non-serpentine without undesirable magnetic emissions. Magnetic field reduction **218** also enables larger diameter set of induction heating circuits **210** without undesirable magnetic emissions. Magnetic field reduction **218** enables use of higher frequency power source **224** without undesirable magnetic emissions. Use of larger diameter set of induction heating circuits **210** with greater spacing in layout **212** can reduce manufacturing difficulty and manufacturing costs of rigid induction tool **206.** Set of induction heating circuits **210** are placed into milled grooves in rigid induction tool **206.** Reducing the quantity of the milled grooves reduces at least one of manufacturing difficulty or manufacturing costs of rigid induction tool **206.** Reducing the difficulty of the layout of the milled grooves reduces at least one of manufacturing difficulty or manufacturing costs of rigid induction tool **206.**

The illustration of induction heating device **202** in **Figure 2** is not meant to imply physical or architectural limitations to the manner in which the disclosure may be implemented. Other components in addition to or in place of the ones illustrated may be used. Some components may be unnecessary. Also, the blocks are presented to illustrate some functional components. One or more of these blocks may be combined, divided, or combined and divided into different blocks when implemented in the present disclosure.
For example, thermal sensors can be present in induction heating device **202.** As another example, second induction heating circuit **250** may be optional.

Although shielding **228** is depicted as associated with first induction heating circuit **231,** shielding **228** can be associated with any desirable induction heating circuits in set of induction heating circuits **210.** Each of first induction heating circuit **231** and second induction heating circuit **250** can have separate shielding **228.** For example, first induction heating circuit **231** can have shielding **228** around conductor **214** and susceptor **216** while second induction heating circuit **250** has a separate length of shielding **228** around susceptor **256** and conductor **254.** Shielding **228** can wrap around both first induction heating circuit **231** and second induction heating circuit **250** such that shielding **228** encompasses susceptor **216,** conductor **214,** susceptor **256,** and conductor **254.** When shielding **228** encircles both first induction heating circuit **231** and second induction heating circuit **250,** shielding **228** may be referred to as "shared shielding" for first induction heating circuit **231** and second induction heating circuit **250.** A diameter of shielding **228** that is shared by both first induction heating circuit **231** and second induction heating circuit **250** is greater than a diameter of shielding **228** that encircles first induction heating circuit **231** and second induction heating circuit **250** individually.

First induction heating circuit **231** and second induction heating circuit **250** can be a twisted **242** pair of induction heating circuits **240.** Shielding **228** can surround twisted **242** pair of induction heating circuits **240,** shielding **228** configured to reduce magnetic fields **222** escaping twisted **242** pair of induction heating circuits **240,** preferably when twisted **242** pair of induction heating circuits **240** is at Curie temperature **220** of twisted **242** pair of induction heating circuits **240.**

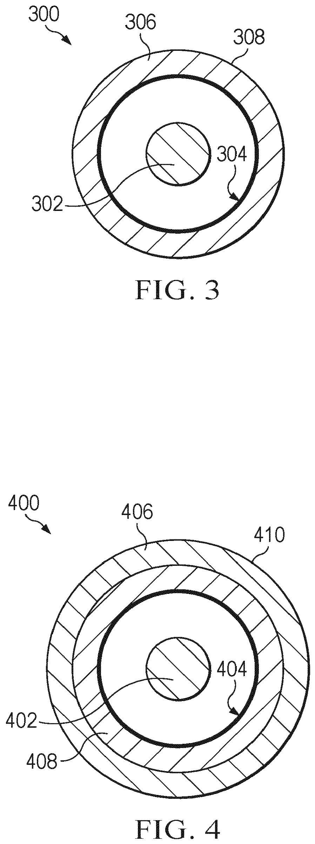

Turning now to **Figure 3****,** an illustration of a cross-sectional view of an induction heating circuit is depicted in accordance with the disclosure. Induction heating circuit **300** is a physical implementation of first induction heating circuit **231** of **Figure 2****.**

Induction heating circuit **300** comprises conductor **302,** susceptor **304,** and magnetic field reduction **306.** Susceptor **304** surrounds conductor **302.** Susceptor **304** is coaxial with conductor **302.** Although susceptor **304** is depicted as a sleeve, susceptor **304** can take any desirable form. Susceptor **304** may take the form of a spiral, a coil, multiple short sleeves, or any other desirable form to surround conductor **302.**

Magnetic field reduction **306** can be configured to reduce magnetic fields escaping induction heating circuit **300** when susceptor **304** is at, or near, the Curie temperature independent of a layout of an induction heating system having induction heating circuit **300.** Magnetic field reduction **306** takes the form of shielding **308.** Shielding **308** surrounds susceptor **304.** Shielding **308** is a conductive metal and is one of a spiral, a braid, or a foil. Shielding **308** blocks magnetic fields from exiting induction heating circuit **300,** preferably after susceptor **304** reaches its Curie temperature through at least one of physically blocking or blocking the magnetic fields using induced currents.

Turning now to **Figure 4****,** an illustration of a cross-sectional view of an induction heating circuit is depicted in accordance with the disclosure. Induction heating circuit **400** is a physical implementation of first induction heating circuit **231** of **Figure 2****.**

Induction heating circuit **400** comprises conductor **402,** susceptor **404,** and magnetic field reduction **406.** Susceptor **404** surrounds conductor **402.** Susceptor **404** is coaxial with conductor **402.** Although susceptor **404** is depicted as a sleeve, susceptor **404** can take any desirable form.
Susceptor **404** may take the form of a spiral, a coil, multiple short sleeves, or any other desirable form to surround conductor **402.**

Magnetic field reduction **406** takes the form of shielding **408.** Shielding **408** surrounds susceptor **404.** Shielding **408** can comprise first layer **410** and second layer **412.** First layer **410** and second layer **412** comprise two different types of shielding of conductive metal selected from a spiral, a foil, and a braid. Shielding **408** blocks magnetic fields from exiting induction heating circuit **400,** preferably after susceptor **404** reaches its Curie temperature through at least one of physically blocking or blocking the magnetic fields using induced currents.

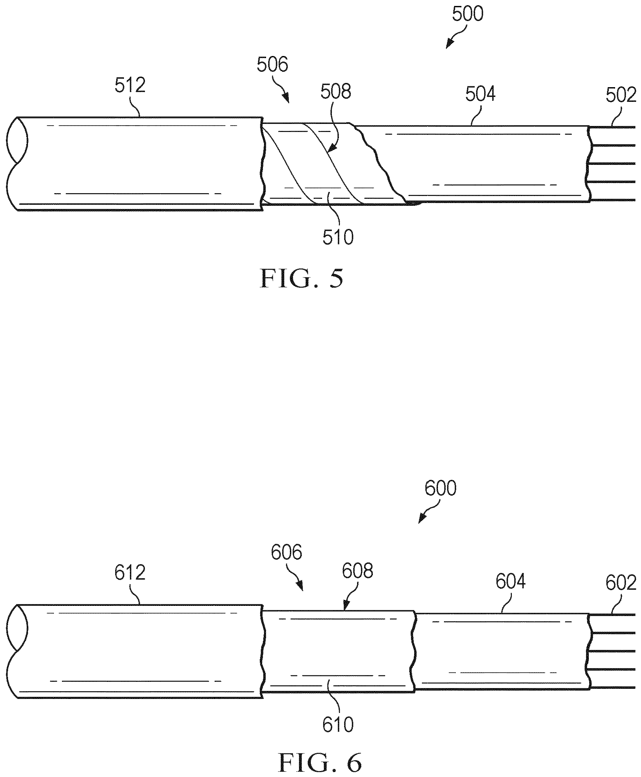

Turning now to **Figure 5****,** an illustration of a partially exploded view of an induction heating circuit with spiral shielding is depicted in accordance with the present disclosure. Induction heating circuit **500** is physical implementation of first induction heating circuit **231** of **Figure 2****.** Induction heating circuit **500** is a physical implementation of induction heating circuit **300** of **Figure 3****.** Induction heating circuit **500** comprises conductor **502,** susceptor **504,** and magnetic field reduction **506.** Susceptor **504** surrounds conductor **502.** Susceptor **504** is coaxial with conductor **502.** Although susceptor **504** is depicted as a sleeve, susceptor **504** can take any desirable form. Susceptor **504** takes the form of a spiral, a coil, multiple short sleeves, or any other desirable form to surround conductor **502.**

Magnetic field reduction **506** takes the form of shielding **508.** Shielding **508** surrounds susceptor **504.** Shielding **508** can comprise spiral **510** formed of a conductive metal. Exterior **512** provides an optional layer of polymeric material. Exterior **512** can be provided for easier handling. Turning now to **Figure 6****,** an illustration of a partially exploded view of an induction heating circuit with foil shielding is depicted in accordance with the disclosure. Induction heating circuit **600** is physical implementation of first induction heating circuit **231** of **Figure 2****.** Induction heating circuit **600** is a physical implementation of induction heating circuit **300** of **Figure 3****.**

Induction heating circuit **600** comprises conductor **602,** susceptor **604,** and magnetic field reduction **606.** Susceptor **604** surrounds conductor **602.** Susceptor **604** is coaxial with conductor **602.** Although susceptor **604** is depicted as a sleeve, susceptor **604** can take any desirable form. Susceptor **604** takes the form of a spiral, a coil, multiple short sleeves, or any other desirable form to surround conductor **602.**

Magnetic field reduction **606** takes the form of shielding **608.** Shielding **608** surrounds susceptor **604.** Shielding **608** can comprise foil **610** formed of a conductive metal. Exterior **612** provides an optional layer of polymeric material. Exterior **612** can be provided for easier handling.

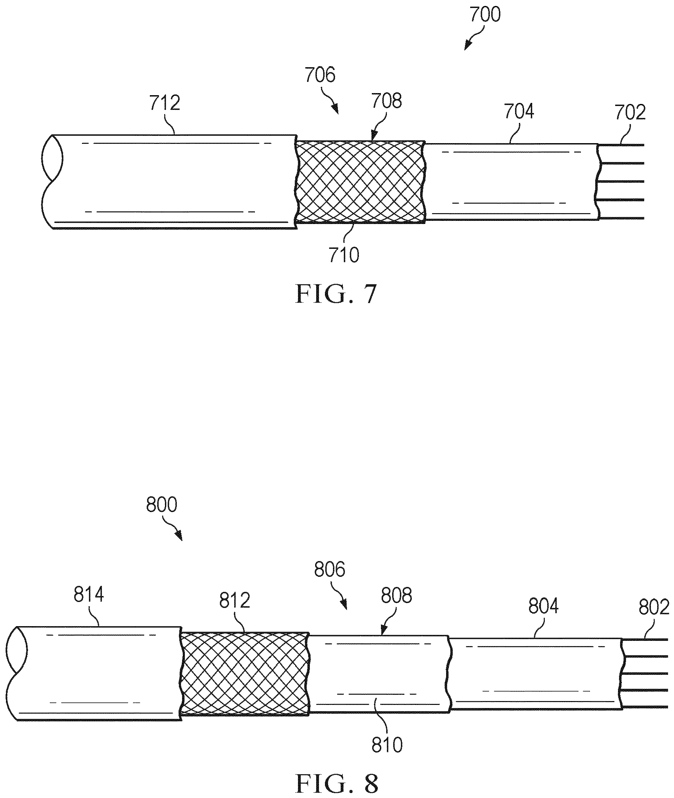

Turning now to **Figure 7****,** an illustration of a partially exploded view of an induction heating circuit with braided shielding is depicted in accordance with the disclosure. Induction heating circuit **700** is physical implementation of first induction heating circuit **231** of **Figure 2****.** Induction heating circuit **700** is a physical implementation of induction heating circuit **300** of **Figure 3****.**

Induction heating circuit **700** comprises conductor **702,** susceptor **704,** and magnetic field reduction **706.** Susceptor **704** surrounds conductor **702.** Susceptor **704** is coaxial with conductor **702.** Although susceptor **704** is depicted as a sleeve, susceptor **704** can take any desirable form. Susceptor **704** may take the form of a spiral, a coil, multiple short sleeves, or any other desirable form to surround conductor **702.**

Magnetic field reduction **706** takes the form of shielding **708.** Shielding **708** surrounds susceptor **704.** Shielding **708** can comprise braid **710** formed of a conductive metal. Exterior **712** provides an optional layer of polymeric material. Exterior **712** can be provided for easier handling.

Turning now to **Figure 8****,** an illustration of a partially exploded view of an induction heating circuit with foil and braided shielding in accordance with the disclosure. Induction heating circuit **800** is physical implementation of first induction heating circuit **231** of **Figure 2****.** Induction heating circuit **800** is a physical implementation of induction heating circuit **300** of **Figure 3****.**

Induction heating circuit **800** comprises conductor **802,** susceptor **804,** and magnetic field reduction **806.** Susceptor **804** surrounds conductor **802.** Susceptor **804** is coaxial with conductor **802.** Although susceptor **804** is depicted as a sleeve, susceptor **804** can take any desirable form. Susceptor **804** may take the form of a spiral, a coil, multiple short sleeves, or any other desirable form to surround conductor **802.**

Magnetic field reduction **806** takes the form of shielding **808.** Shielding **808** surrounds susceptor **804.** Shielding **808** can comprise first layer **810** and second layer **812.** First layer **810** and second layer **812** comprise two different types of shielding of conductive metal selected from a spiral, a foil, and a braid.

First layer **810** may comprise a braid of conductive metal and second layer **812** comprises a foil of conductive metal. In the illustrated example, first layer **810** comprises a foil of conductive metal and second layer **812** comprises a braid of conductive metal. Other combinations of at least one of a spiral, a foil, and a braid can be used. Exterior **814** provides an optional layer of polymeric material. Exterior **814** can be provided for easier handling.

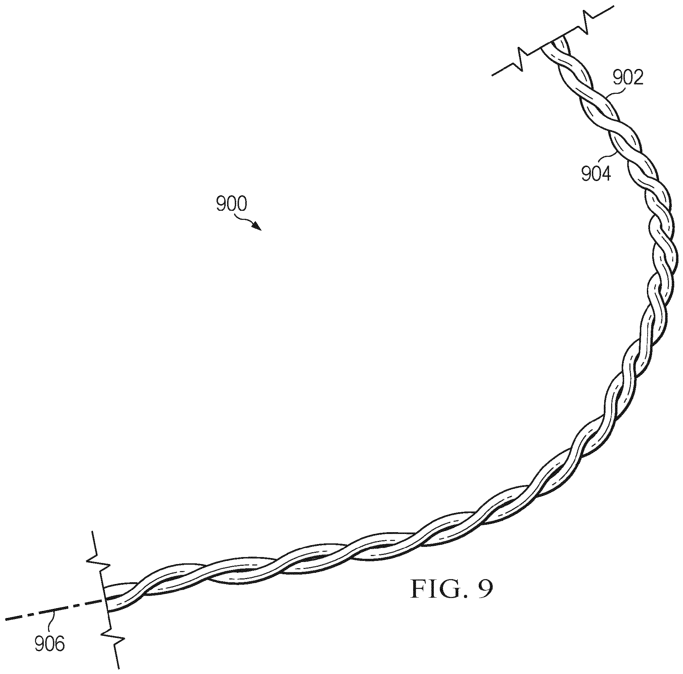

Turning now to **Figure 9****,** an illustration of a side view of an induction heating system with a twisted pair of induction heating circuits is depicted in accordance with the disclosure. Induction heating system **900** can be a physical implementation of induction heating system **208** of **Figure 2****.** Induction heating system **900** comprises first induction heating circuit **902** having a first current direction and second induction heating circuit **904** twisted around first induction heating circuit **902** and central axis **906.** Second induction heating circuit **904** having a second current direction opposite from the first current direction.
First induction heating circuit **902** and second induction heating circuit **904** can be connected by a bend (not depicted) such that first induction heating circuit **902** and second induction heating circuit **904** are formed by a same conductor and a same susceptor surrounding the conductor. First induction heating circuit **902** and second induction heating circuit **904** can be formed by separate lengths of conductor surrounded by susceptor. First induction heating circuit **902** and second induction heating circuit **904** can have separate electrical buses. The magnetic field reduction for induction heating system **900** can be provided by electromagnetic cancellation of the opposite currents.
The magnetic field reduction for induction heating system **900** can be provided by both electromagnetic cancellation and shielding. First induction heating circuit **902** and second induction heating circuit **904** may each comprise shielding configured to reduce magnetic fields escaping a respective induction heating circuit, preferably when a respective susceptor is at, or near, a Curie temperature of the respective susceptor. The shielding (not depicted) can be one length and wraps around itself in induction heating system **900** due to twisting of first induction heating circuit **902** and second induction heating circuit **904.** The shielding for first induction heating circuit **902** and second induction heating circuit **904** can be two separate lengths of shielding.

The shielding for each of the first induction heating circuit and the second induction heating circuit may comprise conductive metal and is at least one of a braid, a foil, or a spiral. Shielding is not necessarily present in induction heating system **900.** Shielding can be present around only one of first induction heating circuit **902** or second induction heating circuit **904.**

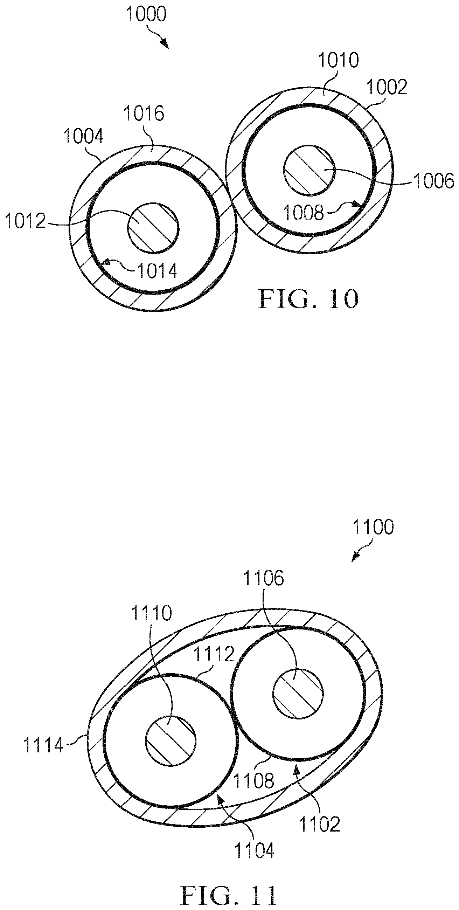

Turning now to **Figure 10****,** an illustration of a cross-sectional view an induction heating system with a twisted pair of induction heating circuits is depicted in accordance with the disclosure. Induction heating system **1000** is a physical implementation of induction heating system **208** of **Figure 2****.** Induction heating system **1000** may be an implementation of induction heating system **900** with shielding around each induction heating circuit.
Induction heating system **1000** comprises pair of induction heating circuits **1001.** Induction heating system **1000** comprises first induction heating circuit **1002** having a first current direction, and second induction heating circuit **1004** twisted around first induction heating circuit **1002** and central axis **1005.** Second induction heating circuit **1004** has a second current direction opposite from the first current direction.

Magnetic field reduction may comprise the design of pair of induction heating circuits **1001** twisted around central axis **1005.** Pair of induction heating circuits **1001** have opposite current directions. The opposite current directions create cancellation of magnetic fields, preferably when susceptor **1008** and susceptor **1014** reach their Curie temperature. The opposite current directions of first induction heating circuit **1002** and second induction heating circuit **1004** cancel out each other's magnetic fields.
First induction heating circuit **1002** of pair of induction heating circuits **1001** comprises conductor **1006** and susceptor **1008.** Induction heating system **1000** can comprise a bend (not depicted) such that pair of induction heating circuits **1001** is formed of one length of conductor and susceptor. Conductor **1006** and conductor **1012** can be formed of a single length of conductive metal. Susceptor **1008** and susceptor **1014** can be formed of a single length of susceptor.
Pair of induction heating circuits **1001** may comprise second induction heating circuit **1004** comprising a second conductor and a second susceptor. Conductor **1006** and conductor **1012** can be formed of separate lengths of conductive material. Susceptor **1008** and susceptor **1014** can be formed of separate lengths of susceptor. First induction heating circuit **1002** and second induction heating circuit **1004** can utilize two separate electrical buses.

Magnetic field reduction may further comprise shielding **1010** surrounding susceptor **1008.** Shielding **1010** blocks magnetic fields from escaping first induction heating circuit **1002.** By blocking magnetic fields, shielding **1010** reduces magnetic fields escaping induction heating system **1000.** Magnetic field reduction may further comprises shielding **1016** surrounding susceptor **1014.** Shielding **1016** blocks magnetic fields from escaping second induction heating circuit **1004.** By blocking magnetic fields, shielding **1016** reduces magnetic fields escaping induction heating system **1000.**
Shielding **1010** and shielding **1016** are formed of conductive metal. At least one of shielding **1010** or shielding **1016** may comprise a spiral of conductive metal. At least one of shielding **1010** or shielding **1016** may comprise a foil of conductive metal. At least one of shielding **1010** or shielding **1016** may comprise braid of conductive metal. Shielding **1010** and shielding **1016** can be individual and separate lengths of shielding. Shielding **1010** and shielding **1016** can be connected by a bend and are part of a continuous length of shielding.

Turning now to **Figure 11****,** an illustration of a cross-sectional view of an induction heating circuit with a twisted pair is depicted in accordance with the disclosure. Induction heating system **1100** is a physical implementation of induction heating system **208** of **Figure 2****.** Induction heating system **1100** can be an implementation of induction heating system **900** with shielding around both of the induction heating circuits.

Induction heating system **1100** comprises pair of induction heating circuits **1101.** Induction heating system **1100** comprises first induction heating circuit **1102** having a first current direction, and second induction heating circuit **1104** twisted around first induction heating circuit **1102** and central axis **1105.** Second induction heating circuit **1104** has a second current direction opposite from the first current direction.

Magnetic field reduction may comprise the design of pair of induction heating circuits **1101** twisted around central axis **1105.** Pair of induction heating circuits **1101** have opposite current directions. The opposite current directions create cancellation of magnetic fields, preferably when susceptor **1108** and susceptor **1112** reach their Curie temperature. The opposite current directions of first induction heating circuit **1102** and second induction heating circuit **1104** cancel out each other's magnetic fields.

First induction heating circuit **1102** of pair of induction heating circuits **1101** comprises conductor **1106** and susceptor **1108.** Induction heating system **1100** may comprise a bend (not depicted) such that pair of induction heating circuits **1101** is formed of one length of conductor and susceptor. Conductor **1106** and conductor **1110** can be formed of a single length of conductive metal. Susceptor **1108** and susceptor **1112** can be formed of a single length of susceptor.

Pair of induction heating circuits **1101** may comprise second induction heating circuit **1104** comprising a second conductor and a second susceptor. Conductor **1106** and conductor **1110** can be formed of separate lengths of conductive material. Susceptor **1108** and susceptor **1112** can be formed of separate lengths of susceptor. First induction heating circuit **1102** and second induction heating circuit **1104** may utilize two separate electrical buses.
Magnetic field reduction may further comprise shielding **1114** surrounding susceptor **1108** and susceptor **1112.** Shielding **1114** blocks magnetic fields from escaping first induction heating circuit **1102** and second induction heating circuit **1104.** By blocking magnetic fields, shielding **1114** reduces magnetic fields escaping induction heating system **1100.** Shielding **1114** is formed of conductive metal. Shielding **1114** may comprise at least one of a spiral of conductive metal, a foil of conductive metal, or a braid of conductive metal.
In induction heating system **1100,** shielding **1114** wraps around both first induction heating circuit **1102** and second induction heating circuit **1104.** Shielding **1114** has a greater diameter than both shielding **1010** and shielding **1016** of **Figure 10** that encompass individual induction heating circuits.

Both induction heating system **1000** and induction heating system **1100** are depicted with shielding. However, an induction heating system, such as induction heating system **900** of **Figure 9****,** with a twisted pair of induction circuits can be utilized without shielding.

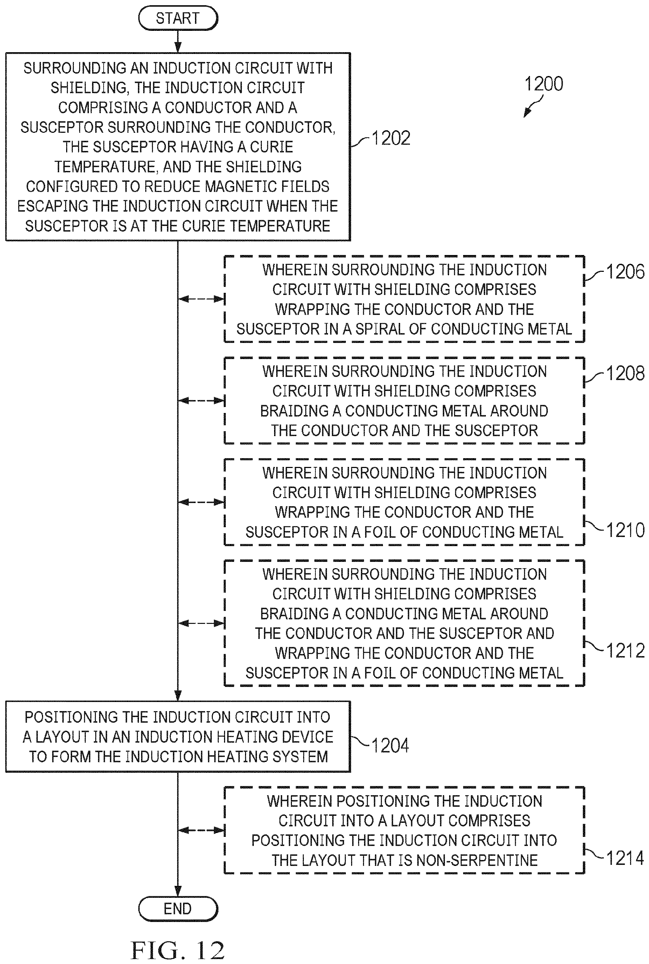

Turning now to **Figure 12****,** a flowchart of a method of reducing magnetic fields escaping an induction heating system during induction heating is depicted in accordance with the disclosure. Method **1200** can be used to form induction heating system **208** of **Figure 2****.** Method **1200** can be used to form any of induction heating circuit **300** of **Figure 3****,** induction heating circuit **400** of **Figure 4****,** induction heating circuit **500** of **Figure 5****,** induction heating circuit **600** of **Figure 6****,** induction heating circuit **700** of **Figure 7****,** or induction heating circuit **800** of **Figure 8****.**

Method **1200** surrounds an induction heating circuit with shielding, the induction heating circuit comprising a conductor and a susceptor surrounding the conductor, the susceptor having a Curie temperature, and the shielding configured to reduce magnetic fields escaping the induction heating circuit, preferably when the susceptor is at the Curie temperature (operation **1202).** Method **1200** positions the induction heating circuit into a layout in an induction heating device to form the induction heating system (operation **1204).** Afterwards, method **1200** terminates. Surrounding the induction heating circuit with shielding may comprise wrapping the conductor and the susceptor in a spiral of conductive metal (operation **1206).** Surrounding the induction heating circuit with shielding may comprise braiding a conductive metal around the conductor and the susceptor (operation **1208).** Surrounding the induction heating circuit with shielding may comprise wrapping the conductor and the susceptor in a foil of conductive metal (operation **1210).** Surrounding the induction heating circuit with shielding may comprise braiding a conductive metal around the conductor and the susceptor and wrapping the conductor and the susceptor in a foil of conductive metal (operation **1212).**

Positioning the induction heating circuit into a layout may comprise positioning the induction heating circuit into the layout that is non-serpentine (operation **1214).** The shielding enables non-serpentine layouts of the induction heating circuit without undesirable quantities of magnetic emissions.

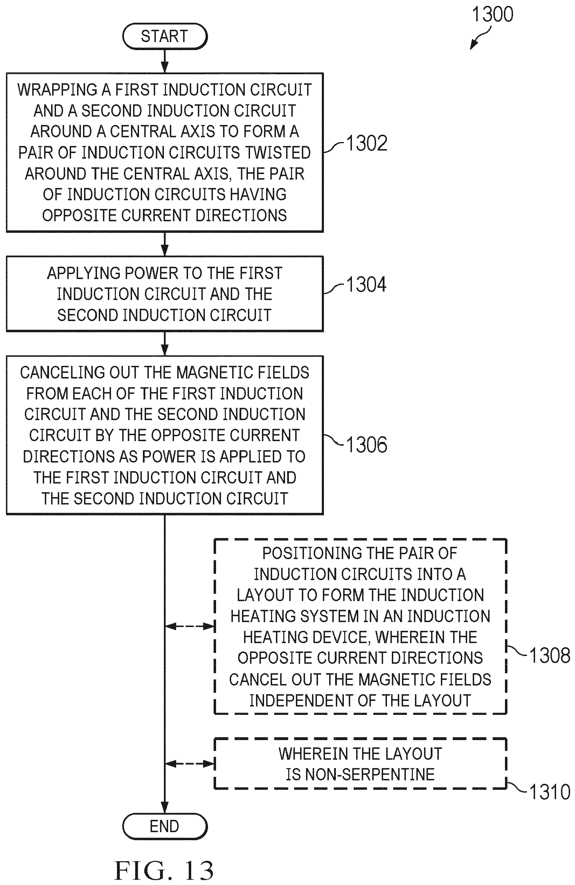

Turning now to **Figure 13****,** a flowchart of a method of reducing magnetic fields escaping an induction heating system during induction heating is depicted in accordance with the disclosure. Method **1300** can be used to form induction heating system **208** of **Figure 2****.** Method **1300** can be used to form any of induction heating system **900** of **Figure 9****,** induction heating system **1000** of **Figure 10****,** or induction heating system **1100** of **Figure 11****.**

Method **1300** wraps a first induction heating circuit and a second induction heating circuit around a central axis to form a pair of induction heating circuits twisted around the central axis, the pair of induction heating circuits having opposite current directions (operation **1302).** Method **1300** applies power to the first induction heating circuit and the second induction heating circuit (operation **1304).** Method **1300** cancels out the magnetic fields from each of the first induction heating circuit and the second induction heating circuit by the opposite current directions as power is applied to the first induction heating circuit and the second induction heating circuit (operation **1306).** Afterwards, method **1300** terminates.

Method **1300** may further comprise positioning the pair of induction heating circuits into a layout to form the induction heating system in an induction heating device, wherein the opposite current directions cancel out the magnetic fields independent of the layout (operation **1308).** The layout can be non-serpentine (operation **1310).** As used herein, the phrase "at least one of," when used with a list of items, means different combinations of one or more of the listed items may be used and only one of each item in the list may be needed. For example, "at least one of item A, item B, or item C" may include, without limitation, item A, item A and item B, or item B. This example also may include item A, item B, and item C or item B and item C. Of course, any combinations of these items may be present. In other examples, "at least one of" may be, for example, without limitation, two of item A; one of item B; and ten of item C; four of item B and seven of item C; or other suitable combinations. The item may be a particular object, thing, or a category. In other words, at least one of means any combination items and number of items may be used from the list but not all of the items in the list are required.
The flowcharts and block diagrams in disclosure illustrate the architecture, functionality, and operation of possible implementations of apparatuses and methods. In this regard, each block in the flowcharts or block diagrams may represent at least one of a module, a segment, a function, or a portion of an operation or step.

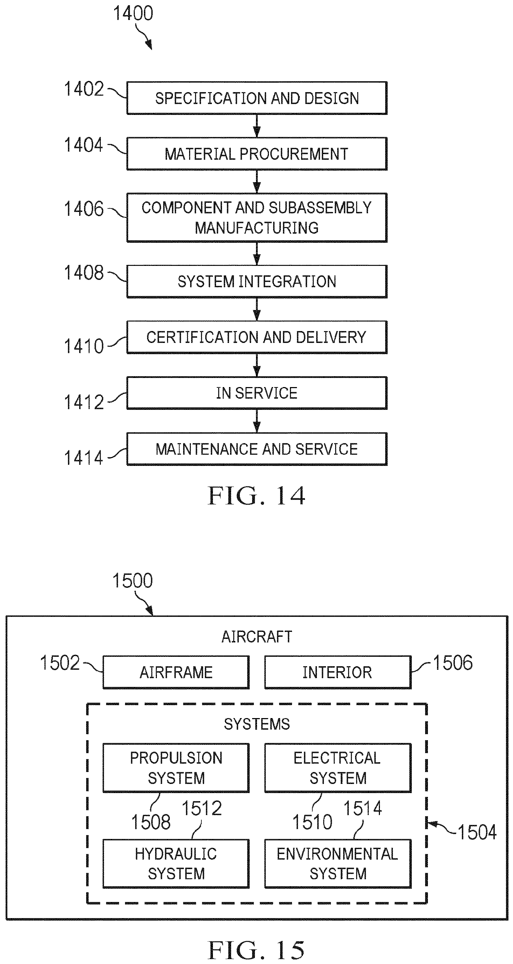

The function or functions noted in the blocks may occur out of the order noted in the figures. For example, in some cases, two blocks shown in succession may be executed substantially concurrently, or the blocks may sometimes be performed in the reverse order, depending upon the functionality involved. Also, other blocks may be added in addition to the illustrated blocks in a flowchart or block diagram. Some blocks may be optional. For example, any of operation **1212** through operation **1218** may be optional.
The present disclosure may be described in the context of aircraft manufacturing and service method **1400** as shown in **Figure 14** and aircraft **1500** as shown in **Figure 15****.** Turning first to **Figure 14****,** an illustration of an aircraft manufacturing and service method is depicted in accordance with the present disclosure. During pre-production, aircraft manufacturing and service method **1400** may include specification and design **1402** of aircraft **1500** in **Figure 15** and material procurement **1404.**

During production, component and subassembly manufacturing **1406** and system integration **1408** of aircraft **1500** takes place. Thereafter, aircraft **1500** may go through certification and delivery **1410** in order to be placed in service **1412.** While in service **1412** by a customer, aircraft **1500** is scheduled for routine maintenance and service **1414,** which may include modification, reconfiguration, refurbishment, or other maintenance and service.

Each of the processes of aircraft manufacturing and service method **1400** may be performed or carried out by a system integrator, a third party, and/or an operator. In these examples, the operator may be a customer. For the purposes of this description, a system integrator may include, without limitation, any number of aircraft manufacturers and major-system subcontractors; a third party may include, without limitation, any number of vendors, subcontractors, and suppliers; and an operator may be an airline, a leasing company, a military entity, a service organization, and so on.

With reference now to **Figure 15****,** an illustration of an aircraft is depicted in which the present disclosure may be implemented. In this example, aircraft **1500** is produced by aircraft manufacturing and service method **1400** of **Figure 14** and may include airframe **1502** with plurality of systems **1504** and interior **1506.** Examples of systems **1504** include one or more of propulsion system **1508,** electrical system **1510,** hydraulic system **1512,** and environmental system **1514.** Any number of other systems may be included.

Apparatuses and methods embodied herein may be employed during at least one of the stages of aircraft manufacturing and service method **1400.** The present disclosure may be manufactured or used during at least one of component and subassembly manufacturing **1406,** system integration **1408,** in service **1412,** or maintenance and service **1414** of **Figure 14****.** A portion of airframe **1502** of aircraft **1500** can be formed by an induction heating circuit formed by method **1200.** A portion of airframe **1502** of aircraft **1500** can be formed by method **1300.** An induction heating device formed by either method **1200** or method **1300** can be used during component and subassembly manufacturing **1406.** Portions of method **1300** can be performed during component and subassembly manufacturing **1406.** Induction heating device **202** can be used to form a composite structure during component and subassembly manufacturing **1406.** Induction heating device **202** can be used to form a composite structure during maintenance and service **1314** to form a replacement part.

The present disclosure can enable use of Smart Susceptor heating and metal tooling for high rate production without autoclaves. The present disclosure provides a shield for the smart susceptor magnetic field so that metal tooling can be used for high rate production rather than just non-metallic tooling.

The present disclosure provides protection against thermal issues when using Smart Susceptor with metal tooling. Magnetic field intensity outside of an induction circuit can be reduced using shielding. The shielding can take the form of at least one of foil wrap, braid sleeve, or wire wound. The shielding material can take the form of at least one of metal foil, metal coated polymer sheet, tinned copper, carbon fiber, or graphite. Adding electromagnetic shielding elements to the outside of the induction heating circuit mitigates emissions.

Litz wire arranged in a plane in alternating (counter running) directions can be wrapped about a susceptor wire to shield the magnetic field of the susceptor. The susceptor wires can be twisted so that current can run parallel to cancel out susceptor magnetic field. In both cases, the current is running in alternate/parallel directions at the same time.

Reducing electromagnetic emissions by either shielding or twisted design of induction heating circuits allows for more flexibility on the layout of induction heating circuits within induction heating devices. The present disclosure allows for induction heating circuits to not be constrained to parallel circuits. The present disclosure provides for farther spacing between induction heating circuits and for larger, high amperage circuits.

If an induction heating circuit of the disclosure is integrated into a tooling surface, the magnetic field reduction comprising one of shielding or twisted design, will prevent or reduce unintended eddy currents. If an induction heating circuit of the disclosure is integrated into a tooling surface, inadvertent heating of the tool will be reduced or eliminated. Concentrating the field near the smart susceptor can improve smart susceptor heating efficiency.

A twisted wire design can be provided to provide electromagnetic cancellation. A single length of susceptor and conductor in a circuit doubling back using a bend provides cancellation. Parallel circuits formed of separate lengths of susceptor and conductor would also provide cancellation. The cancellation provided by parallel circuits can be less than the cancellation provided by a single length with a bend.

## Claims

1. An induction heating circuit (231) comprising:
a conductor (214),
a susceptor (216) having a Curie temperature (220) surrounding the conductor (214); and
magnetic field reduction or blocking means (218) for reducing or blocking magnetic fields (222).

2. The induction heating circuit (231) according to claim 1, wherein the magnetic field reduction or blocking means (218) reduce or block magnetic fields (222) when the susceptor (216) is at, or near, the Curie temperature (220).

3. The circuit (231) of claim 1 or 2, wherein the magnetic field reduction or blocking means (218) comprises shielding (228) surrounding the susceptor (216), preferably wherein the shielding (228) comprises one or more of the following:
a spiral (232) of conductive metal (230), a braid (236) of conductive metal (230), a foil (234) of conductive metal (230),copper or aluminum.

4. The circuit (231) according to any of the preceding claims, wherein the magnetic field reduction or blocking means comprises a pair of induction heating circuits twisted around a central axis, wherein the pair of induction heating circuits have opposite current directions, and wherein a first induction heating circuit of the pair of induction heating circuits comprises the conductor and the susceptor.

5. The circuit (231) of claim 4, further comprising a bend (258) such that the pair of induction heating circuits (240) is formed of the conductor (214) and the susceptor (216).

6. The circuit (231) of claim 4 or 5, wherein the pair of induction heating circuits further comprises a second induction heating circuit comprising a second conductor and a second susceptor.

7. The circuit (231) of claim 6, wherein the first induction heating circuit (231) and the second induction heating circuit (250) are formed by separate lengths of conductor (214) surrounded by the susceptor (216), the first induction heating circuit (231) and second induction heating circuit (250) having separate electrical buses.

8. The circuit (231) of claim 6 or 7, wherein the second induction heating circuit (250) comprises shielding (228), the shielding of the second induction heating circuit (250) preferably corresponding to the shielding (228) of first induction heating circuit (231).

9. An induction heating system (208) comprising a circuit (213) as claimed in any of the preceding claims, and an induction heating device (202), preferably wherein the circuit (213) is positioned in a layout (212) of the induction heating device (202, more preferably wherein the layout is non-serpentine.

10. A method of forming an induction heating system, comprising the step of providing an induction heating circuit with magnetic field reduction or blocking means for reducing or blocking magnetic fields escaping the induction heating circuit preferably when a susceptor of the induction heating circuit is at, or near, the Curie temperature, preferably further comprising positioning the induction heating circuit into a layout in an induction heating device, which layout is preferably non-serpentine.

11. The method of claim 10, wherein the step of providing the induction heating circuit with magnetic field reduction or blocking means comprises arranging a shielding around the induction heating circuit, preferably wherein arranging the shielding comprises positioning a conductive metal around a conductor in the circuit, more preferably wherein the conductive metal is wrapped and/or braided around the conductor.

12. The method of claims 10 or 11, wherein the step of providing the induction heating circuit with magnetic field reduction or blocking means comprises wrapping a first induction heating circuit and a second induction heating circuit around a central axis to form a pair of induction heating circuits twisted around the central axis, the pair of induction heating circuits having opposite current directions.

13. A method of reducing or blocking magnetic fields from escaping an induction heating system during induction heating, the method comprising:
applying power to an induction heating circuit of the induction heating system to generate heat; and
reducing or blocking magnetic fields from exiting the induction heating circuit, preferably when a susceptor of the induction heating circuit is at the Curie temperature.

14. The method of claim 13, wherein the magnetic fields are reduced or blocked by a shielding surrounding the induction heating circuit, preferably by way of the shielding physically reducing or blocking the magnetic fields and/or by way of using an induced current with an opposing field in the shielding, preferably after the susceptor reaches the Curie temperature.

15. The method of claim 13 or 14, comprising:
wrapping a first induction heating circuit and a second induction heating circuit around a central axis to form a pair of induction heating circuits twisted around the central axis, the pair of induction heating circuits having opposite current directions;
applying power to the first induction heating circuit and the second induction heating circuit; and
canceling out the magnetic fields from each of the first induction heating circuit and the second induction heating circuit by the opposite current directions as power is applied to the first induction heating circuit and the second induction heating circuit.
